# EUROPEAN PATENT SPECIFICATION

(11) **EP 2 549 542 B1**
(45) Date of publication and mention of the grant of the patent: **14.09.2016**
(21) Application number: 12176663.8
(22) Date of filing: 17.07.2012
(51) Int. Cl.: H01L 31/0224, H01L 31/0352, H01L 31/18

(54) **Oxygen getter layer for photovoltaic devices and methods of their manufacture**
Dünnfilmfotovoltaikvorrichtungen mit Sauerstoff-Getter und Herstellungsverfahren dafür
Couche dégazeur d'oxygène pour dispositifs photovoltaïques et leurs procédés de fabrication

(30) Priority: 22.07.2011 US 201113188782
(43) Date of publication of application: 23.01.2013
(73) Proprietor: First Solar Malaysia SDN.BHD, Aman (MY)
(72) Inventor: Grossman, Robert Dwayne, Arvada, CO Colorado 80004 (US); Feldman-Peabody, Scott Daniel, Arvada, CO Colorado 80004 (US); Knapp, Jeffrey Todd, Arvada, CO Colorado 80004 (US)
(74) Representative: Thurston, Joanna

(56) References cited:
- US-A1- 2009 297 886
- DYER S E ET AL: "Preparation and piezoresistive properties of reactively sputtered indium tin oxide thin films", THIN SOLID FILMS, ELSEVIER-SEQUOIA S.A. LAUSANNE, CH, vol. 288, no. 1, 15 November 1996 (1996-11-15), pages 279-286, XP004049564, ISSN: 0040-6090, DOI: 10.1016/S0040-6090(96)08865-7

## Description

### BACKGROUND OF THE INVENTION

The subject matter disclosed herein relates generally to an oxygen getter layer for use in a photovoltaic device, along with their methods of deposition. More particularly, the subject matter disclosed herein relates to an oxygen getter layer for use in cadmium telluride thin film photovoltaic devices and their methods of manufacture. Document by S.E Dyer et al, Thin Film Solibs 288, 279-286 (1996) describes the use of oxygen getter layers.

Cadmium stannate (CTO) is an excellent transparent conductive oxide (TCO) material. For example, CTO has superior transmissivity and conductivity to nearly every other transparent conductor currently available. The reason behind this transparency and conductivity is believed to be the high mobility of the material and the high carrier concentration. The high mobility appears to be derived from a consistent structure and relatively large grains. The high carrier concentration appears to be driven by the material's ability to support a large number of oxygen vacancies in the structure.

The high mobility and high carrier concentration are typically obtained through the use of a high temperature anneal. It is believed that a sufficiently high temperature anneal may crystallize the CTO to achieve high Hall mobilities (e.g., about 60 to about 80 cm²/(V•s)); however, there is sufficient oxygen still present within the film and above the film to inhibit the creation of oxygen vacancies. Previous attempts to increase the number of oxygen vacancies in the CTO after annealing have included the use of a cadmium sulfide film in proximity to the CTO film during annealing, which serves to both keep cadmium in the CTO structure by providing an over pressure of cadmium and promoting oxygen vacancies by being a reducing agent. However, this proximity annealing method is difficult and expensive to achieve in a manufacturing environment. Other methods have included using low annealing pressures to promote the removal of oxygen from the TCO. However, since CTO contains cadmium, annealing at such low pressures tends to promote cadmium loss as well, which can cause the film to revert to a less conductive tin oxide material.

As such, a need exists for methods of increasing the oxygen vacancies in the TCO layer in the manufacture of thin film photovoltaic devices. In particular, a need exists for methods of increasing the oxygen vacancies in a CTO film without significant loss of cadmium.

### BRIEF DESCRIPTION OF THE INVENTION

Aspects and advantages of the invention will be set forth in part in the following description, or may be obvious from the description, or may be learned through practice of the invention.

Methods are generally disclosed for forming a front contact for use in a thin film photovoltaic device. According to one embodiment, a transparent conductive oxide layer and an oxygen getter layer can be formed on a transparent substrate. The transparent conductive oxide layer and the oxygen getter layer can then be annealed together such that oxygen atoms move from the transparent conductive oxide layer into the oxygen getter layer.

In one particular embodiment, a top oxygen getter layer is formed on a transparent substrate; a transparent conductive oxide layer is formed on the first oxygen getter layer; and a bottom oxygen getter layer is formed on the transparent conductive oxide layer. The top oxygen getter layer, the transparent conductive oxide layer, and the bottom oxygen getter layer can then be annealed together such that oxygen atoms move from the transparent conductive oxide layer into the top oxygen getter layer and the bottom oxygen getter layer.

Thin film photovoltaic, devices are also generally disclosed. In one embodiment, the device includes a transparent substrate; a crystallized transparent conductive oxide layer on the transparent substrate (e.g., where the crystallized transparent conductive oxide layer contains less oxygen atoms than as deposited); an oxidized oxygen getter layer on the transparent substrate (e.g., where the oxidized oxygen getter layer contains more oxygen atoms than as deposited); and, a photovoltaic heterojunction on the crystallized transparent conductive oxide layer.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

A full and enabling disclosure of the present invention, including the best mode thereof, directed to one of ordinary skill in the art, is set forth in the specification, which makes reference to the appended figures, in which:
Fig. 1 shows a general schematic of a cross-sectional view of an example cadmium telluride thin film photovoltaic device including an oxygen getter layer;
Fig. 2 shows a general schematic of a cross-sectional view of another example cadmium telluride thin film photovoltaic device including an oxygen getter layer;
Fig. 3 shows a general schematic of a cross-sectional view of an alternative example cadmium telluride thin film photovoltaic device including a pair of oxygen getter layers;
Fig. 4 shows a general schematic of a cross-sectional view of an alternative example cadmium telluride thin film photovoltaic device including two pair of index matching layers and a pair of oxygen getter layers;
Fig. 5 shows a flow diagram of an example method of manufacturing a thin film photovoltaic device;
Fig. 6 shows a flow diagram of another example method of manufacturing a thin film photovoltaic device;
Fig. 7 shows another embodiment of the device, where the oxygen getter layer can act as a resistive transparent buffer layer; and,
Fig. 8 shows yet another embodiment of the device, where the oxygen getter layer can act as an index matching layer.

Repeat use of reference characters in the present specification and drawings is intended to represent the same or analogous features or elements.

### DETAILED DESCRIPTION OF EMBODIMENTS OF THE INVENTION

In the present disclosure, when a layer is being described as "on" or "over" another layer or substrate, it is to be understood that the layers can either be directly contacting each other or have another layer or feature between the layers, unless expressly stated to the contrary. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

In general, thin film photovoltaic devices are presently disclosed having at least one oxygen getter layer in proximity to the transparent conductive oxide (TCO) layer during its high temperature anneal. The oxygen getter layer is configured to be have a greater affinity for oxygen than the TCO material (e.g., be more reactive with oxygen) in order to remove oxygen from the TCO layer during annealing. Specifically, oxygen travels from the TCO layer into the oxygen getter layer during annealing such that the crystallized TCO layer has less oxygen after annealing than as deposited and the annealed oxygen getter layer (i.e., oxygenated oxygen getter layer) has more oxygen after annealing than as deposited. Without wishing to be bound by any particular theory, it is believed that the movement of oxygen from the TCO layer into the oxygen getter layer(s) during annealing can promote oxygen vacancies in the TCO layer, which can lead to high carrier concentration. Thus, the crystallized TCO layer formed after annealing can have high conductivity (e.g., greater than about 5500 S-cm).

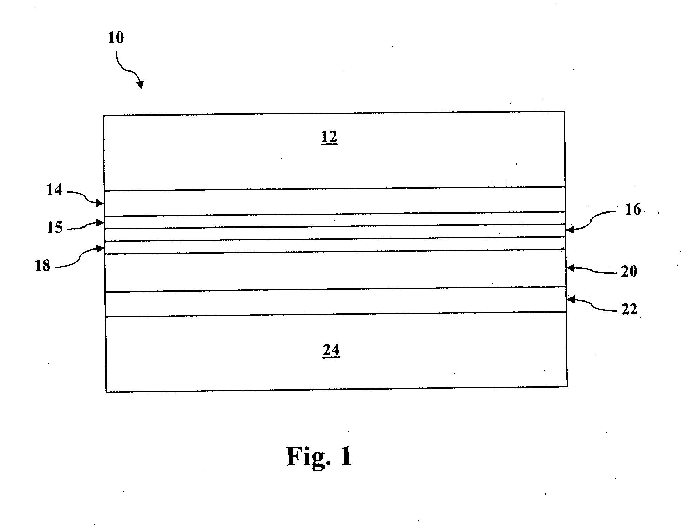

Although shown and described as a cadmium telluride thin film photovoltaic device 10 in Figs. 1-4, the oxygen getter layer(s) can be included in any type of photovoltaic device that uses a transparent conductive oxide layer. Specifically, a transparent conductive oxide layer and at least one oxygen getter layer can be formed on a transparent substrate in any configuration as described in greater detail below.

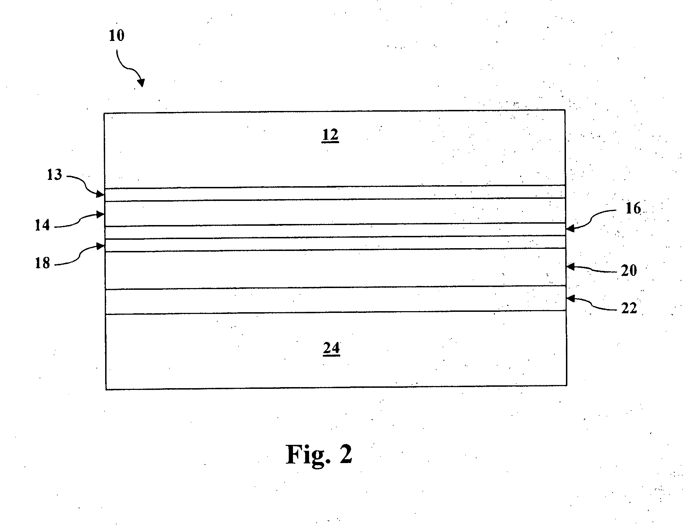

Fig. 1 represents an example cadmium telluride thin film photovoltaic device 10 having a bottom oxygen getter layer 15 positioned between the transparent conductive oxide (TCO) layer 14 and the photovoltaic heteroj unction formed from the cadmium sulfide layer 18 and the cadmium telluride layer 20. In the embodiment shown, a resistant transparent buffer (RTB) layer 16 is positioned between the TCO layer 14 and the photovoltaic heterojunction (shown as the cadmium sulfide layer 18 and the cadmium telluride layer 20). Fig. 2 shows an alternative embodiment of an example cadmium telluride thin film photovoltaic device 10 having a top oxygen getter layer 13 positioned between the transparent substrate 12 (e.g., a glass substrate) and the TCO layer 14.

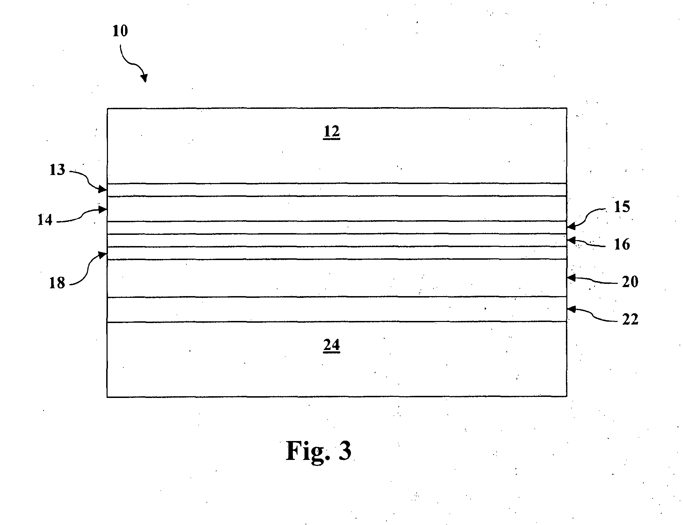

Fig. 3 shows another example cadmium telluride thin film photovoltaic device 10 having two oxygen getter layers: a top oxygen getter layer 13 positioned between the glass substrate 12 and the TCO layer 14 and a bottom oxygen getter layer 15 positioned between the TCO layer 14 and the photovoltaic heterojunction formed from the cadmium sulfide layer 18 and the cadmium telluride layer 20. In this embodiment, the top oxygen getter layer 13 and the bottom oxygen getter layer 15 can be formed from the same material(s) or different material(s).

In the embodiments shown, the top oxygen getter layer 13 and the bottom oxygen getter layer 15 are in direct contact with the TCO layer 14 to maximize oxygen movement from the deposited TCO layer 14 into the top oxygen getter layer 13 and/or bottom oxygen getter layer 15 during annealing.

The oxygen getter layer(s), including the top oxygen getter layer 13 and/or the bottom oxygen getter layer 15, can be deposited as a material that has a greater affinity for oxygen than the TCO layer 14. For example, the oxygen getter layer(s) can be a relatively thin metal layer, such as having a thickness of about 5 nm to about 40 nm (e.g., about 10 nm to about 25 nm). The metal of the oxygen getter layer(s) in this embodiment can include, for example, tin, zinc, titanium, zirconium, vanadium, aluminum, indium, magnesium, tantalum, niobium, or alloys or mixtures thereof. In particular embodiments, the oxygen getter layer can include tin, titanium, aluminum, or mixtures thereof. In other particular embodiments, the oxygen getter layer can include zinc, cadmium, or mixtures thereof. For instance, the oxygen getter layer(s) include, in one embodiment, a zinc thin film layer having a thickness of about 15 nm to about 25 nm (e.g., about 20 nm).

In one particular embodiment, the oxygen getter layer(s) can be substantially free from oxygen when deposited (i.e., prior to annealing). As used herein, the term "substantially free" means no more than an insignificant trace amount present and encompasses completely free (e.g., 0 molar % up to 0.01 molar %). However, in other embodiments, the oxygen getter layer(s) can be deposited as a partially oxidized film.

Depositing the oxygen getter layer(s) can be achieved through any suitable process, including but not limited to, sputtering, chemical vapor deposition, spray pyrolysis, or any other suitable deposition method. In one particular embodiment, when the oxygen getter layer(s) is deposited to be substantially free from oxygen, the oxygen getter layer(s) can be sputtered from a metal target in an inert atmosphere (e.g., argon). In this embodiment, the metal target and/or the inert atmosphere can be substantially free from oxygen.

Such oxygen getter layer(s) can be particularly useful in conjunction with a TCO layer 14 having a thickness in the range of about 200 nm to about 500 nm, such as about 275 nm to about 325 nm, and/or when the TCO layer 14 includes cadmium stannate, (e.g., consisting essentially of cadmium stannate) when deposited. Generally, the TCO layer 14 is shown on the glass substrate 12 of the example device 10, either directly as shown in Fig. 1 or with an intermediate layer (e.g., the top oxygen getter layer 13) therebetween as shown in Figs. 2 and 3. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, indium tin oxide, zinc stannate, cadmium stannate, cadmium oxide, or mixtures thereof. Additionally, the TCO layer 14 can include other conductive, transparent materials. The TCO layer 14 can also include dopants (e.g., fluorine, tin, etc.) and other materials, as desired.

The TCO layer 14 can be formed by sputtering, chemical vapor deposition, spray pyrolysis, or any other suitable deposition method. In one particular embodiment, the TCO layer 14 can be formed by sputtering (e.g., DC sputtering or RF sputtering) on the glass substrate 12. For example, a cadmium stannate layer can be formed by sputtering a hot-pressed target containing stoichiometric amounts of SnO₂ and CdO onto the glass substrate 12 in a ratio of about 1 to about 2. The cadmium stannate can alternatively be prepared by using cadmium acetate and tin (II) chloride precursors by spray pyrolysis. In certain embodiments, the TCO layer 14 can have a thickness between about 0.1 µm and about 1 µm, for example from about 0.1 µm to about 0.5 µm, such as from about 0.25 µm to about 0.35 µm.

Once deposited, the TCO layer 14 and the oxygen getter layer(s) (e.g., the top oxygen getter layer 13 and/or the bottom oxygen getter layer 15) can be annealed together via heating to an anneal temperature. For example, the anneal temperature can be about 580° C to about 680° C. At temperatures higher than this range, the glass may begin to melt; while at temperatures below this range, the anneal time required may be too long for efficient manufacturing processes. For example, the TCO layer 14 and the oxygen getter layer(s) can be annealed at the anneal temperature for a time sufficient to transfer at least some amount of oxygen from the TCO layer 14 into the top oxygen getter layer 13 and/or the bottom oxygen getter layer 15, such as for about 2 minutes to about 1 hour. Annealing causes the TCO layer 14 to become crystallized (i.e., a crystallized TCO layer 14) and the top oxygen getter layer 13 and/or the bottom oxygen getter layer 15 to become oxidized.

For example, the TCO layer 14 can reduce its oxygen content during the annealing by about 5 molar % to about 50 molar % (e.g., about 10 molar % to about 40 molar %) depending on its composition. Likewise, the oxygen getter layer 13 can increase its oxygen content during annealing to become substantially fully oxidized from its deposited state (e.g., Sn can be oxidized to SnO₂, Al can be oxidized to Al₂O3, Ti can be oxidized to TiO₂, Zr can be oxidized to ZrO₂, Zn can be oxidized to ZnO, etc.).

In one particular embodiment, the transparent conductive oxide layer and the oxygen getter layer can be annealed together in an annealing atmosphere that is substantially free from oxygen.

As stated, the TCO layer 14 and the top oxygen getter layer 13 and/or the bottom oxygen getter layer 15 can have their as-deposited stoichiometry and structure until the layers are collectively annealed together (i.e., simultaneously). However, after annealing, the TCO layer 14 has less oxygen present than as deposited while the oxygen getter layer(s) (e.g., the top oxygen getter layer 13 and/or the bottom oxygen getter layer 15) has more oxygen present than as deposited.

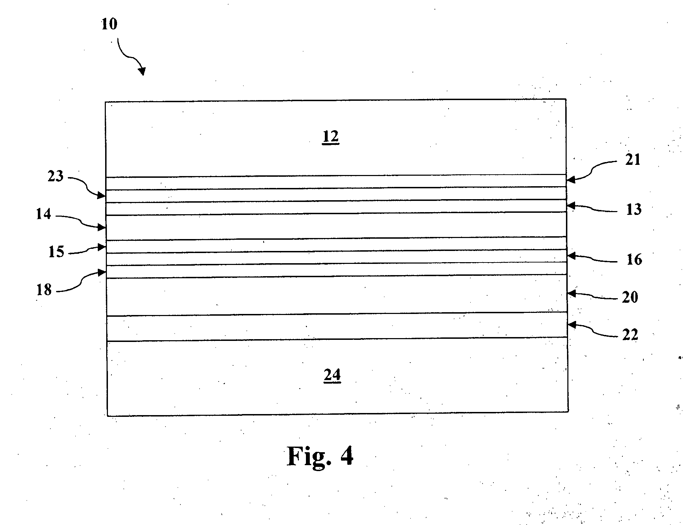

Fig. 4 shows the inclusion of a pair of index matching layers in the form of a high index layer 21 and a low index layer 23 between the TCO layer 14 and the glass substrate 12. The index matching layers can help reduce reflective loss of light entering the device. Thus, the index matching layers can minimize the amount of reflective losses, leading to maximizing the amount of current that can be generated from the device. Additionally, the index matching layers can generally even out color variations seen on the glass face of the photovoltaic module during use. The index matching layers may also further serve as diffusion barriers for contaminants coming from or through the glass substrate into the underlying thin film layers.

The refractive index (sometimes referred to as the index of refraction) of a substance is a measure of the speed of light in that substance, expressed as a ratio of the speed of light in vacuum relative to that in the considered medium. A simple mathematical description of the refractive index (n) is as follows:
n = velocity of light in a vacuum / velocity of light in medium.

As light exits the medium, it may also change its propagation direction in proportion to the refractive index (see Snell's law). By measuring the angle of incidence and angle of refraction of the light beam, the refractive index (n) can be determined. The refractive index of materials varies with the frequency of radiated light, resulting in a slightly different refractive index for each color. Unless otherwise stated, the values of refractive indices are calculated at a wavelength of 632 nanometers (nm). Such calculations are routinely performed in the art and methods of conducting them are readily known. One typical method of measuring these films is through the use of ellipsometry or spectroscopic ellipsometry (both techniques may include the use of multiple angles of incident light). For both techniques, the change in phase and polarization of a reference beam of light may be used to fit a model from which can be extracted the refractive index of the material.

In most embodiments, the TCO layer 14 can have a refractive index of about 1.8 to about 2.2 (e.g., about 1.9 to about 2), as can the RTB layer 16, depending on the materials used to form these layers. The cadmium sulfide layer 18 can have a refractive index of about 2.3 to about 2.5 (e.g., about 2.4), and the cadmium telluride layer 20 can have a refractive index of about 2.9 to about 3.1 (e.g., about 3.0). The glass substrate 12 can have a refractive index of about 1.4 to about 1.6 (e.g., about 1.5).

The high index layer 21 generally has a refractive index of about 2.0 or greater (e.g., about 2.0 to about 2.5). In certain embodiments, the high index layer 21 can have a refractive index of about 2.05 to about 2.4, such as about 2.1 to about 2.3. In certain embodiments, the high index layer 21 can be a thin film layer including, but not limited to, titanium dioxide (TiO₂), tin oxide, zinc oxide, zinc tin oxide (ZTO), indium oxide (In₂O₃), hafnium oxide (HfO₂), tantalum pentoxide (Ta₂O₅), niobium oxide (Nb₂O₅), zirconium oxide (ZrO₂), yttrium oxide (Y₂O₃), ytterbium oxide (Yb₂O₃), silicon nitride (Si₃N₄), aluminum nitride (AlN), or mixtures thereof. Other materials may also be included in the high index layer 11, such as dopants, impurities, etc,

The low index layer 23 generally has a refractive index of about 1.5 or less (e.g., about 1.1 to about 1.5). In certain embodiments, the low index layer 23 can have a refractive index of about 1.15 to about 1.4, such as about 1.1 to about 1.3. In certain embodiments, the low index layer 23 can be a thin film layer including, but not limited to, silicon dioxide (SiO₂), magnesium fluoride (MgF₂), lithium fluoride (LiF), calcium fluoride (CaF₂), sodium fluoride (NaF), other group I or group II fluorides, or mixtures thereof. Other materials may also be included in the low index layer 23, such as dopants, impurities, etc.

The thicknesses of the high index layer 21 and the low index layer 23 can be varied according to the materials in the layers 21, 23 and the components of the window film stack. In most embodiments, the thickness of each of the high index layer 21 and the low index layer 23 can be about 5 nm to about 60 nm (e.g., about 10 nm to about 50 nm). In one particular embodiment, the high index layer 21 can be a titanium oxide layer having a thickness of about 10 nm to about 15 nm (e.g., about 11 nm to about 12 nm, such as about 11.5 nm), and the low index layer 23 can be a silicon dioxide layer having a thickness of about 30 nm to about 33 nm (e.g., about 31 nm to about 32 nm, such as about 31.5 nm). In an alternative embodiment, the high index layer 21 can be a ZTO layer having a thickness of about 20 nm to about 27 nm (e.g., about 22 nm to about 26 nm), and the low index layer 23 can be a silicon dioxide layer having a thickness of about 20 nm to about 30 nm (e.g., about 26 nm to about 28 nm, such as about 27 nm).

Although shown with the high index layer 21 adjacent to and directly on the glass substrate 12 followed by the low index layer 23 adjacent to and directly on the high index layer 21, other configurations may be utilized. For example, the low index layer 23 can be adjacent to and directly on the glass substrate 12 followed by the high index layer 21 being adjacent to and directly on the low index layer 23. Additionally, multiple high index layers and low index layers can be present between the pair of index matching layers 21, 23 and the TCO layer 14, arranged such that the high indexing layers and low indexing layers are in alternating orientation.

As stated, the example devices 10 of Figs. 1-4 include a top sheet of glass substrate 12 employed as the substrate. In these embodiments, the glass substrate 12 can be referred to as a "superstrate", as it is the substrate on which the subsequent layers are formed even though it faces upward to the radiation source (e.g., the sun) when the photovoltaic device 10 is in used. The top sheet of glass substrate 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass substrate 12 can be a low iron float glass containing less than about 0.15% by weight iron (Fe), and may have a transmissiveness of about 0.9 or greater in the spectrum of interest (e.g., wavelengths from about 300 nm to about 900 nm).

The TCO layer 14 and the oxygen getter layer(s) (e.g., the top oxygen getter layer 13 and/or the bottom oxygen getter layer 15) are deposited on the glass substrate 12 as discussed above.

A resistive transparent buffer layer 16 (RTB layer) is shown on the TCO layer 14 on the example photovoltaic devices 10, either directly on the TCO layer 14 as shown in Fig. 2 or with a bottom oxygen getter layer 15 therebetween as shown in Figs. 1 and 3. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.5 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 20. Thus, it is believed that the RTB layer 16 allows for improved adhesion and/or interaction between the TCO layer 14 and the cadmium telluride layer 20, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (SnO₂), which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spray-pyrolysis, or any other suitable deposition method. In one particular embodiment, the RTB layer 16 can be formed by sputtering (e.g., DC sputtering or RF sputtering) on the TCO layer 14. For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

A cadmium sulfide layer 18 is shown on RTB layer 16 of the example device 10. The cadmium sulfide layer 18 is a n-type layer that generally includes cadmium sulfide (CdS) but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., direct current (DC) sputtering or radio frequency (RF) sputtering) on the RTB layer 16. Sputtering deposition generally involves ejecting material from a target, which is the material source, and depositing the ejected material onto the substrate to form the film. DC sputtering generally involves applying a current to a metal target (i.e., the cathode) positioned near the substrate (i.e., the anode) within a sputtering chamber to form a direct-current discharge. The sputtering chamber can have a reactive atmosphere (e.g., an oxygen atmosphere, nitrogen atmosphere, fluorine atmosphere) that forms a plasma field between the metal target and the substrate. The pressure of the reactive atmosphere can be between about 1 mTorr and about 20 mTorr for magnetron sputtering. When metal atoms are released from the target upon application of the voltage, the metal atoms can react with the plasma and deposit onto the surface of the substrate. For example, when the atmosphere contains oxygen, the metal atoms released from the metal target can form a metallic oxide layer on the substrate. The current applied to the source material can vary depending on the size of the source material, size of the sputtering chamber, amount of surface area of substrate, and other variables. In some embodiments, the current applied can be from about 2 amps to about 20 amps. Conversely, RF sputtering generally involves exciting a capacitive discharge by applying an alternating-current (AC) or radiofrequency (RF) signal between the target (e.g., a ceramic source material) and the substrate. The sputtering chamber can have an inert atmosphere (e.g., an argon atmosphere) having a pressure between about 1 mTorr and about 20 mTorr.

Due to the presence of the RTB layer 16, the cadmium sulfide layer 18 can have a thickness that is less than about 0.1 µm, such as between about 10 nm and about 100 nm, such as from about 50 nm to about 80 nm, with a minimal presence of pinholes between the TCO layer 14 and the cadmium sulfide layer 18. Additionally, a cadmium sulfide layer 18 having a thickness less than about 0.1 µm reduces any absorption of radiation energy by the cadmium sulfide layer 18, effectively increasing the amount of radiation energy reaching the underlying cadmium telluride layer 20.

A cadmium telluride layer 20 is shown on the cadmium sulfide layer 18 in the example devices 10. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the adsorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 1.5 µm and about 4 µm, such as about 2 µm to about 3 µm.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 425° C) for a sufficient time (e.g., from about 1 to about 40 minutes) to create a quality p-type layer of cadmium telluride. Without wishing to be bound by theory, it is believed that annealing the cadmium telluride layer 20 (and the device 10) decreases the deep-defect density and makes the CdTe layer more p-type. Additionally, the cadmium telluride layer 20 can recrystallize and undergo grain regrowth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTeO₃, CdTe₂O₅, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 22 and/or can create a Cu-doped CdTe layer. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 250° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, silver, or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

The encapsulating glass 24 is also shown in the example cadmium telluride thin film photovoltaic device 10 of Fig. 1.

Other components (not shown) can be included in the example device 10, such as buss bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

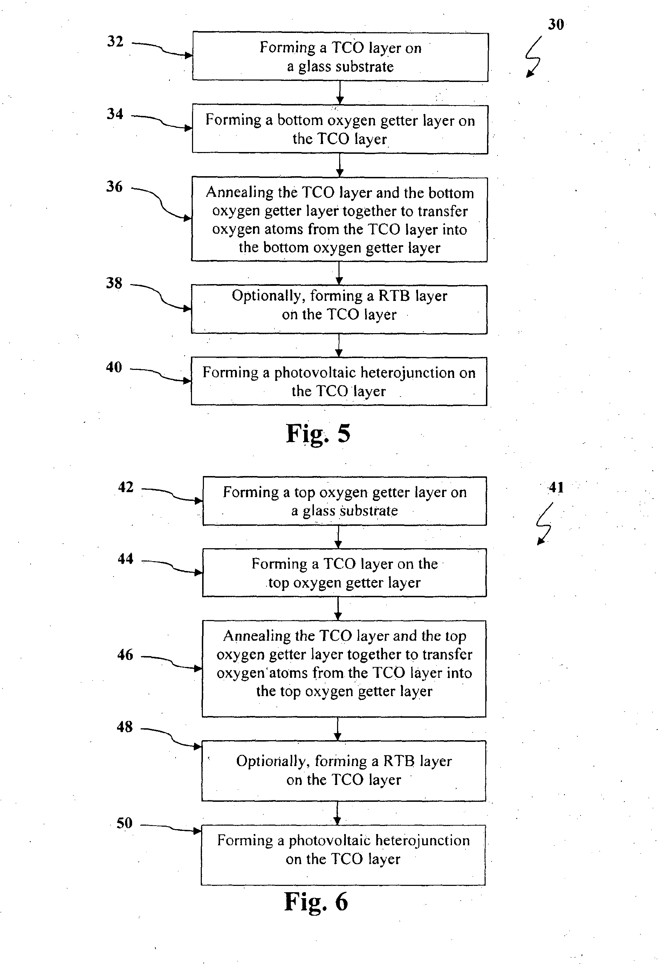

Fig. 5 shows a flow diagram of an example method 30 of manufacturing a photovoltaic device according to one embodiment of the present invention. According to the example method 30, a TCO layer is formed on a glass superstrate at 32, and a bottom oxygen getter layer is formed on the TCO layer at 34. The TCO layer and the bottom oxygen getter layer are then annealed together to transfer oxygen atoms from the TCO layer into the bottom oxygen getter layer at 36. At 38, a RTB layer is optionally formed on the TCO layer. A photovoltaic heterojunction is formed on the TCO layer (e.g., on the RTB layer, when present) at 40.

Fig. 6 shows a flow diagram of an alternate method 41 of manufacturing a photovoltaic device according to one embodiment of the present invention. According to the example method 41, a top oxygen getter layer is formed on a glass superstrate at 42, and a TCO layer is formed on the top oxygen getter layer at 44. The TCO layer and the top oxygen getter layer are then annealed together to transfer oxygen atoms from the TCO layer into the top oxygen getter layer at 46. At 48, a RTB layer is optionally formed on the TCO layer. A photovoltaic heterojunction is formed on the TCO layer (e.g., on the RTB layer, when present) at 50.

In one particular embodiment, the photovoltaic heterojunction includes a cadmium sulfide layer is formed on the TCO layer and a cadmium telluride layer formed on the cadmium sulfide layer.

One of ordinary skill in the art should recognize that other processing and/or treatments can be included in the methods 30 and 41. For instance, when including a cadmium sulfide layer and a cadmium telluride layer, the cadmium telluride layer can be annealed in the presence of cadmium chloride, washed to remove any CdO formed on the surface, and doped with copper. Back contact layer(s) can be applied over the cadmium telluride layer, and an encapsulating glass can be applied over the back contact layer. Additionally, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

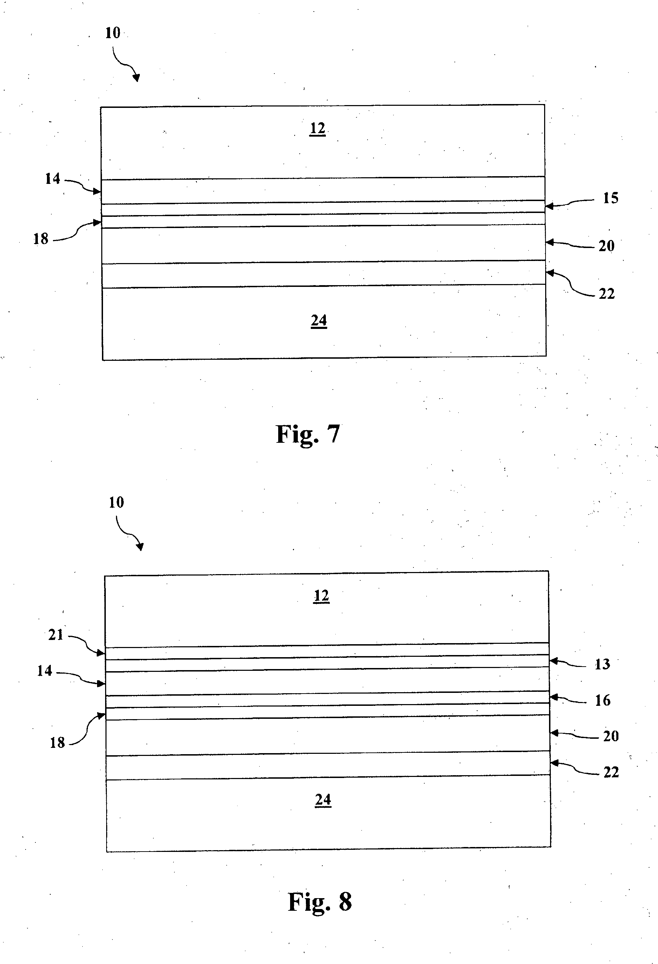

Fig. 7 shows another embodiment of the device 10, where the bottom oxygen getter layer 15 is formed from a material that, upon oxidation after annealing, can act as a resistive transparent buffer layer. As such, a separate RTB layer may be omitted from the device 10, leaving only the bottom oxygen getter layer 15 between the TCO layer 14 and the cadmium sulfide layer 18, or at least may allow for a thinner RTB layer to be formed therebetween than would otherwise had been used but for the presence of the oxygen getter layer 15. For example, the bottom oxygen getter layer 15 can be deposited to include zinc and/or tin (e.g., a zinc-tin, alloy) and can be oxidized upon annealing to form a zinc-tin oxide layer ("ZTO"), such as described above with respect to the RTB layer.

Fig. 8 shows yet another embodiment of the device 10, where the top oxygen getter layer 13 is formed from a material that, upon oxidation after annealing, can act as a index matching layer, in conjunction with another index layer (e.g., shown as a high index layer 21). As such, a separate low index layer may be omitted from the device 10, leaving only the top oxygen getter layer 13 between the high index matching layer 21 and the TCO layer 14, or at least may allow for a thinner additional index matching layer to be formed therebetween than would otherwise had been used but for the presence of the oxygen getter layer 13. For example, the top oxygen getter layer 13 can be deposited to include aluminum and can be oxidized upon annealing to form an aluminum oxide layer that acts as an index matching layer in the device 10.

As indicated from the description of Figs. 7 and 8, it can be seen that a oxygen getter layer 13 and/or 15 can, in the broadest sense, be chosen so as to serve oxygen getter during anneal and processing of the TCO layer, while serving a separate long-term role in the finished device 10.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method of forming a front contact for use in a thin film photovoltaic device (10), the method comprising:
forming a transparent conductive oxide layer (14) on a transparent substrate (12);
forming an oxygen getter layer (13, 15) on the transparent substrate (12);
**characterized in that** the method further comprises:
annealing the transparent conductive oxide layer (14) and the oxygen getter layer (13, 15) together such that oxygen atoms move from the transparent conductive oxide layer (14) into the oxygen getter layer (13, 15).

2. The method of claim 1, wherein the oxygen getter layer (13, 15) is substantially free from oxygen prior to annealing.

3. The method of claim 2, wherein the oxygen getter layer (13, 15) consists essentially of at least one metal prior to annealing.

4. The method of claim 2, wherein the oxygen getter layer (13, 15) comprises:
tin, titanium, aluminum, or mixtures thereof; or
zinc, cadium, or mixtures thereof.

5. The method of any one of claims 1 to 4, wherein the transparent conductive oxide layer (14) comprises cadium stannate.

6. The method of any one claims 1 to 5, wherein:
the oxygen layer (13,15) has a thickness of about 5 nm to about 40 nm; and/or
the transparent conductive oxide layer (14) has a thickness of about 200 nm to about 500 nm.

7. The method of any one of claims 1 to 6, wherein the transparent conductive oxide layer (14) and the oxygen getter layer (13,15) are annealed together via heating to an anneal temperature, wherein the anneal temperature is about 580°C to about, 680°C.

8. The method of any one of claims 1 to 7, wherein the transparent conductive oxide layer (14) and the oxygen getter layer (13,15) are annealed together in an annealing atmosphere that is substantially free from oxygen.

9. The method of any one of claims 1 to 8, further comprising:
forming a photovoltaic heterojunction on the oxygen getter layer (13,15).

10. The method of claim 9, wherein the oxygen getter layer (13,15) is between the transparent conductive oxide layer (14) and the cadium sulfide layer (18), and wherein the oxygen getter layer (13, 15), upon annealing, acts as a resistive transparent buffer layer (16) in the thin film photovoltaic device (10).

11. The method of any one of claims 1 to 10, wherein the oxygen getter layer (13,15) is between the transparent substrate (12) and the transparent conductive oxide layer (14), further comprising:
forming a first index matching layer (21) on the transparent substrate (12), wherein the oxygen getter layer (13,15), upon annealing, acts as a second index matching layer (23) in the thin film photovoltaic device (10).

12. The method of claim 1, comprising
forming a first oxygen getter layer (13) on the transparent substrate (12); forming a transparent conductive oxide layer (14) on the first oxygen getter layer (13);
forming a second oxygen getter layer (15) on the transparent conductive oxide layer (14); and,
annealing the first oxygen getter layer (13), the transparent conductive oxide layer (14), and the second oxygen getter layer (15) together such that oxygen atoms move from the transparent conductive oxide layer (14) into the first oxygen getter layer (13) and the second oxygen getter layer (15).

13. A thin film photovoltaic device (10) obtained by the method of any of claims 1-12 comprising:
a transparent substrate (12);
a crystallized transparent conductive oxide layer (14) on the transparent substrate (12);
an oxidized oxygen getter layer (13,15) on the transparent substrate (12), wherein the oxidized oxygen getter layer (13,15) contains more oxygen atoms than as deposited; and,
a photovoltaic heterojunction on the crystallized transparent conductive oxide layer (14); **characterised in that** the crystallized transparent conductive oxide layer (14) contains less oxygen atoms than as deposited.

14. The device of claim 13, wherein:
the oxidized oxygen getter later (13,15) is between the crystallized transparent conductive oxide layer (14) and the photovoltaic heterojunction: and/or
the oxidized oxygen getter layer (13,15) is between the transparent substrate (12) and the crystallized transparent conductive oxide layer (14).

15. The device of claim 14, further comprising:
a second oxidized oxygen getter layer between the crystallized transparent conductive oxide layer (14) and the photovoltaic heterojunction, wherein the second oxidized oxygen getter layer contains more oxygen atoms than as deposited; and
wherein, preferably, the oxidized oxygen getter layer has a thickness of about 5 nm to about 40 nm; and/or
the crystallized transparent conductive oxide layer comprises cadium stannate.

## Patentansprüche

1. Verfahren zur Bildung eines Frontkontakts zur Verwendung in einer Dünnfilmphotovoltaikvorrichtung (10), wobei das Verfahren Folgendes umfasst:
Bilden einer transparenten leitenden Oxidschicht (14) auf einem transparenten Substrat (12);
Bilden einer Sauerstoffgetterschicht (13, 15) auf dem transparenten Substrat (12); **dadurch gekennzeichnet, dass** das Verfahren ferner Folgendes umfasst:
derartiges gemeinsames Tempern der transparenten leitenden Oxidschicht (14) und der Sauerstoffgetterschicht (13, 15), dass sich Sauerstoffatome von der transparenten leitenden Oxidschicht (14) in die Sauerstoffgetterschicht (13, 15) bewegen.

2. Verfahren nach Anspruch 1, wobei die Sauerstoffgetterschicht (13, 15) vor dem Tempern im Wesentlichen sauerstofffrei ist.

3. Verfahren nach Anspruch 2, wobei die Sauerstoffgetterschicht (13, 15) vor dem Tempern im Wesentlichen aus zumindest einem Metall besteht.

4. Verfahren nach Anspruch 2, wobei die Sauerstoffgetterschicht (13, 15)
Zinn, Titan, Aluminium oder Gemische davon; oder
Zink, Cadmium oder Gemische davon
umfasst.

5. Verfahren nach einem der Ansprüche 1 bis 4, wobei die transparente leitende Oxidschicht (14) Cadmiumstannat umfasst.

6. Verfahren nach einem der Ansprüche 1 bis 5, wobei
die Sauerstoffgetterschicht (13, 15) eine Dicke von etwa 5 nm bis etwa 40 nm aufweist; und/oder
die transparente leitende Oxidschicht (14) eine Dicke von etwa 200 nm bis etwa 500 nm aufweist.

7. Verfahren nach einem der Ansprüche 1 bis 6, wobei die transparente leitende Oxidschicht (14) und die Sauerstoffgetterschicht (13, 15) durch Erhitzen auf eine Tempertemperatur gemeinsam getempert werden, wobei die Tempertemperatur etwa 580 °C bis etwa 680 °C beträgt.

8. Verfahren nach einem der Ansprüche 1 bis 7, wobei die transparente leitende Oxidschicht (14) und die Sauerstoffgetterschicht (13, 15) in einer Temperatmosphäre, die im Wesentlichen sauerstofffrei ist, gemeinsam getempert werden.

9. Verfahren nach einem der Ansprüche 1 bis 8, ferner umfassend:
Bilden eines photovoltaischen Heteroübergangs auf der Sauerstoffgetterschicht (13, 15).

10. Verfahren nach Anspruch 9, wobei sich die Sauerstoffgetterschicht (13, 15) zwischen der transparenten leitenden Oxidschicht (14) und einer Cadmiumsulfidschicht (18) befindet, und wobei die Sauerstoffgetterschicht (13, 15) beim Tempern als widerstandsbehaftete transparente Pufferschicht (16) in der Dünnfilmphotovoltaikvorrichtung (10) wirkt.

11. Verfahren nach einem der Ansprüche 1 bis 10, wobei sich die Sauerstoffgetterschicht (13, 15) zwischen dem transparenten Substrat (12) und der transparenten leitenden Oxidschicht (14) befindet, ferner umfassend:
Bilden einer ersten Indexanpassungsschicht (21) auf dem transparenten Substrat (12), wobei die Sauerstoffgetterschicht (13, 15) beim Tempern als zweite Indexanpassungsschicht (23) in der Dünnfilmphotovoltaikvorrichtung (10) wirkt.

12. Verfahren nach Anspruch 1, umfassend:
Bilden einer ersten Sauerstoffgetterschicht (13) auf dem transparenten Substrat (12);
Bilden einer transparenten leitenden Oxidschicht (14) auf der ersten Sauerstoffgetterschicht (13);
Bilden einer zweiten Sauerstoffgetterschicht (15) auf der transparenten leitenden Oxidschicht (14); und
derartiges gemeinsames Tempern der ersten Sauerstoffgetterschicht (13), der transparenten leitenden Oxidschicht (14) und der zweiten Sauerstoffgetterschicht (15), dass sich Sauerstoffatome von der transparenten leitenden Oxidschicht (14) in die erste Sauerstoffgetterschicht (13) und die zweite Sauerstoffgetterschicht (15) bewegen.

13. Dünnfilmphotovoltaikvorrichtung (10), die durch das Verfahren nach einem der Ansprüche 1 bis 12 erhalten wird, umfassend:
ein transparentes Substrat (12);
eine kristallisierte transparente leitende Oxidschicht (14) auf dem transparenten Substrat (12);
eine oxidierte Sauerstoffgetterschicht (13, 15) auf dem transparenten Substrat (12), wobei die oxidierte Sauerstoffgetterschicht (13, 15) mehr Sauerstoffatome enthält, als abgelagert wurden; und
einen photovoltaischen Heteroübergang auf der kristallisierten transparenten leitenden Oxidschicht (14); **dadurch gekennzeichnet, dass** die kristallisierte transparente leitende Oxidschicht (14) weniger Sauerstoffatome enthält, als abgelagert wurden.

14. Vorrichtung nach Anspruch 13, wobei
sich die oxidierte Sauerstoffgetterschicht (13, 15) zwischen der kristallisierten transparenten leitenden Oxidschicht (14) und dem photovoltaischen Heteroübergang befindet; und/oder
sich die oxidierte Sauerstoffgetterschicht (13, 15) zwischen dem transparenten Substrat (12) und der kristallisierten transparenten leitenden Oxidschicht (14) befindet.

15. Vorrichtung nach Anspruch 14, ferner umfassend:
eine zweite oxidierte Sauerstoffgetterschicht zwischen der kristallisierten transparenten leitenden Oxidschicht (14) und dem photovoltaischen Heteroübergang, wobei die zweite oxidierte Sauerstoffgetterschicht mehr Sauerstoffatome enthält, als abgelagert wurden; und
wobei, vorzugsweise, die oxidierte Sauerstoffgetterschicht eine Dicke von etwa 5 nm bis etwa 40 nm aufweist; und/oder
die kristallisierte transparente leitende Oxidschicht Cadmiumstannat umfasst.

## Revendications

1. Procédé de formation d'une électrode de contact destinée à être utilisée dans un dispositif photovoltaïque à couches minces (10), le procédé comprenant :
la formation d'une couche d'oxyde transparent conducteur (14) sur un substrat transparent (12) ;
la formation d'une couche dégazeur d'oxygène (13, 15) sur le substrat transparent (12) ; **caractérisé en ce que** le procédé comprend, en outre :
le recuit de la couche d'oxyde transparent conducteur (14) et de la couche dégazeur d'oxygène (13, 15) ensemble, de sorte que les atomes d'oxygène se déplacent de la couche d'oxyde transparent conducteur (14) dans la couche dégazeur d'oxygène (13, 15).

2. Procédé selon la revendication 1, dans lequel la couche dégazeur d'oxygène (13, 15) est sensiblement exempte d'oxygène avant le recuit.

3. Procédé selon la revendication 2, dans lequel la couche dégazeur d'oxygène (13, 15) consiste essentiellement en au moins un métal avant le recuit.

4. Procédé selon la revendication 2, dans lequel la couche dégazeur d'oxygène (13, 15) comprend :
de l'étain, du titane, de l'aluminium ou des mélanges de ceux-ci ou
du zinc, du cadmium ou des mélanges de ceux-ci.

5. Procédé selon l'une quelconque des revendications 1 à 4, dans lequel la couche d'oxyde transparent conducteur (14) comprend du stannate de cadmium.

6. Procédé selon l'une quelconque des revendications 1 à 5, dans lequel :
la couche d'oxygène (13, 15) a une épaisseur d'environ 5 nm à environ 40 nm ;
et/ou
la couche d'oxyde transparent conducteur (14) a une épaisseur d'environ 200 nm à environ 500 nm.

7. Procédé selon l'une quelconque des revendications 1 à 6, dans lequel la couche d'oxyde transparent conducteur (14) et la couche dégazeur d'oxygène (13, 15) sont recuites ensemble par chauffage à une température de recuit, dans lequel la température de recuit est d'environ 580°C à environ 680°C.

8. Procédé selon l'une quelconque des revendications 1 à 7, dans lequel la couche d'oxyde transparent conducteur (14) et la couche dégazeur d'oxygène (13, 15) sont recuites ensemble dans une atmosphère de recuit, qui est sensiblement exempte d'oxygène.

9. Procédé selon l'une quelconque des revendications 1 à 8, comprenant, en outre :
la formation d'une hétérojonction photovoltaïque sur la couche dégazeur d'oxygène (13, 15).

10. Procédé selon la revendication 9, dans lequel la couche dégazeur d'oxygène (13, 15) se trouve entre la couche d'oxyde transparent conducteur (14) et la couche de sulfure de cadmium (18), et dans lequel la couche dégazeur d'oxygène (13, 15), lors du recuit, agit comme une couche tampon transparente résistive (16) dans le dispositif photovoltaïque à couches minces (10).

11. Procédé selon l'une quelconque des revendications 1 à 10, dans lequel la couche dégazeur d'oxygène (13, 15) se trouve entre le substrat transparent (12) et la couche d'oxyde transparent conducteur (14), comprenant, en outre :
la formation d'une première couche de correspondance d'index (21) sur le substrat transparent (12), dans lequel la couche dégazeur d'oxygène (13, 15), lors du recuit, agit comme une seconde couche de correspondance d'index (23) dans le dispositif photovoltaïque à couches minces (10).

12. Procédé selon la revendication 1, comprenant :
la formation d'une première couche dégazeur d'oxygène (13) sur le substrat transparent (12) ;
la formation d'une couche d'oxyde transparent conducteur (14) sur la première couche dégazeur d'oxygène (13) ;
la formation d'une seconde couche dégazeur d'oxygène (15) sur la couche d'oxyde transparent conducteur (14) ; et,
le recuit de la première couche dégazeur d'oxygène (13), de la couche d'oxyde transparent conducteur (14) et de la seconde couche dégazeur d'oxygène (15) ensemble, de sorte que les atomes d'oxygène se déplacent de la couche d'oxyde transparent conducteur (14) dans la première couche dégazeur d'oxygène (13) et la seconde couche dégazeur d'oxygène (15).

13. Dispositif photovoltaïque à couches minces (10), obtenu par le procédé selon l'une quelconque des revendications 1 à 12, comprenant :
un substrat transparent (12) ;
une couche d'oxyde transparent conducteur cristallisée (14) sur le substrat transparent (12) ;
une couche dégazeur d'oxygène oxydée (13, 15) sur le substrat transparent (12), dans laquelle la couche dégazeur d'oxygène oxydée (13, 15) contient plus d'atomes d'oxygène que ceux déposés et,
une hétérojonction photovoltaïque sur la couche d'oxyde transparent conducteur cristallisée (14) ; **caractérisé en ce que** la couche d'oxyde transparent conducteur cristallisée (14) contient moins d'atomes d'oxygène que ceux déposés.

14. Dispositif selon la revendication 13, dans lequel :
la couche dégazeur d'oxygène oxydée (13, 15) se trouve entre la couche d'oxyde transparent conducteur cristallisée (14) et l'hétérojonction photovoltaïque ; et/ou
la couche dégazeur d'oxygène oxydée (13, 15) se trouve entre le substrat transparent (12) et la couche d'oxyde transparent conducteur cristallisée (14).

15. Dispositif selon la revendication 14, comprenant, en outre :
une seconde couche dégazeur d'oxygène oxydée entre la couche d'oxyde transparent conducteur cristallisée (14) et l'hétérojonction photovoltaïque, dans lequel la seconde couche dégazeur d'oxygène oxydée contient plus d'atomes d'oxygène que ceux déposés ; et,
dans lequel, de préférence, la couche dégazeur d'oxygène oxydée a une épaisseur comprise entre environ 5 nm et environ 40 nm ; et/ou
la couche d'oxyde transparent conducteur cristallisée comprend du stannate de cadmium.
